(19) Europäisches Patentamt
European Patent Office
Office européen des brevets

(11) **EP 4 332 598 A1**

(12) **EUROPEAN PATENT APPLICATION**

(43) Date of publication:
**06.03.2024 Bulletin 2024/10**

(21) Application number: **22193100.9**

(22) Date of filing: **31.08.2022**

(51) International Patent Classification (IPC):
**G01R 31/392** (2019.01)　　**G01R 31/367** (2019.01)

(52) Cooperative Patent Classification (CPC):
**G01R 31/392; G01R 31/367**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **TWAICE Technologies GmbH 80807 München (DE)**

(72) Inventors:
 • **SINGER, Jan 81371 München (DE)**
 • **KARGER, Alexander 81667 München (DE)**
 • **AYGÜL, Deniz Navdar 80802 München (DE)**
 • **RAMOS ZAYAS, Juan 81675 München (DE)**
 • **PHAM, Bastian Huy 81373 München (DE)**
 • **PUTZ, Reinhard 80939 München (DE)**

(74) Representative: **Kraus & Lederer PartGmbB Thomas-Wimmer-Ring 15 80539 München (DE)**

(54) **ESTIMATION OF CALENDAR AGING OF BATTERY CELLS**

(57)　Various examples of the disclosure pertain to determining a set of calendar aging values of a test cell of a rechargeable battery, e.g., LIBs. The set of calendar aging values of the test cell of the rechargeable battery corresponds to a set of Temperature-State of Charge (T-SOC) value pairs. The set of calendar aging values of the test cell of the rechargeable battery is determined based on a battery-generic reference model for calendar aging of a (specific or random) battery cell and on a further set of calendar aging values of the test cell of the rechargeable battery. The further set of calendar aging values is obtained/derived from measurements of the test cell of the rechargeable battery and corresponds to a further set of T-SOC value pairs.

Fig. 3

EP 4 332 598 A1

**Description**

TECHNICAL FIELD

Various examples of the disclosure generally pertain to determining calendar aging (or ageing) values of a cell, e.g., a test cell, of a rechargeable battery.

BACKGROUND

Rechargeable batteries such as lithium-ion batteries (LIBs) are the main choice of power source for portable electronics, grid energy storage systems, and electric vehicles (EVs). However, recent trends in large-scale electrification of vehicles have increased their demand significantly. Despite high energy and power density, capacity and power fade is a major concern for further expansion of EVs because of long calendar life requirement (e.g., up to 15 years). The LIBs capacity and power fade can be ascribed to cycle aging and calendar aging. LIBs are also widely used in stationary energy storage, e.g., in connection with photovoltaic power plants.

Calendar aging (also referred to as calendric aging) comprises all aging processes that lead to a degradation of a battery cell independent of charge-discharge cycling. It is an important factor in many applications of LIBs where the operation periods are substantially shorter than the idle intervals, such as in EVs. Storage conditions such as ambient temperature and state-of-charge (SOC) can influence calendar aging.

Currently, many studies on calendar aging of LIBs were conducted using data about the influence of storage conditions on capacity fades in cells of LIBS obtained during storage tests over months and/or years. Since such storage tests are quite time-consuming, these studies usually considered only a few SOCs and/or a few ambient temperatures. Hence, these studies cannot easily cover a broad SOC range, e.g., from 10 to 100%, as well as a wide temperature range, and are consequently not able to precisely report the relationship between capacity fade and storage conditions, e.g., SOC as well as temperature. Furthermore, with reduced product lifecycles, it is oftentimes required to obtain accurate estimates of the calendar aging of LIBs within only a few weeks or months from start-of-production.

SUMMARY

A need exists for techniques of determining calendar aging values of a test cell of a rechargeable battery. A need exists for techniques that enable determining the calendar aging values efficiently and precisely. A need exists for techniques that are widely applicable to various types of battery cells.

This need is met by the features of the independent claims. The features of the dependent claims define embodiments.

A computer-implemented method is provided. The method includes obtaining a battery-generic reference model for calendar aging of a battery cell. The method further includes measuring a first set of calendar aging values of a test cell of a re-chargeable battery for a first set of Temperature-State of Charge (T-SOC) value pairs. The method still further includes determining a second set of calendar aging values of the test cell of the rechargeable battery for a second set of T-SOC value pairs based on the first set of calendar aging values and the battery-generic reference model.

A computer program or a computer-program product or a computer-readable storage medium including program code is provided. The program code can be loaded and executed by at least one processor. Upon executing the program code, the at least one processor performs a method. The method includes obtaining a battery-generic reference model for calendar aging of a battery cell. The method further includes measuring a first set of calendar aging values of a test cell of a re-chargeable battery for a first set of Temperature-State of Charge (T-SOC) value pairs. The method still further includes determining a second set of calendar aging values of the test cell of the rechargeable battery for a second set of T-SOC value pairs based on the first set of calendar aging values and the battery-generic reference model.

A computing device comprising a processor and a memory is provided. The processor is configured to load program code from the memory and execute the program code. Upon executing the program code the processor performs a method. The method includes obtaining a battery-generic reference model for calendar aging of a battery cell. The method further includes measuring a first set of calendar aging values of a test cell of a re-chargeable battery for a first set of Temperature-State of Charge (T-SOC) value pairs. The method still further includes determining a second set of calendar aging values of the test cell of the rechargeable battery for a second set of T-SOC value pairs based on the first set of calendar aging values and the battery-generic reference model.

It is to be understood that the features mentioned above and those yet to be explained below may be used not only in the respective combinations indicated, but also in other combinations or in isolation without departing from the scope of the invention.

BRIEF DESCRIPTION OF THE DRAWINGS

FIG. 1 schematically illustrates an exemplary aging grid of a battery-generic reference model for calendar aging of a battery cell according to various examples.

FIG. 2A schematically illustrates a system according to various examples.

FIG. 2B schematically illustrates a computing device according to various examples.

FIG. 3 is a flowchart of a method according to various examples.

FIG. 4 schematically illustrates an exemplary workflow for determining a set of calendar aging values using the method of FIG. 3.

FIG. 5 schematically illustrates various aging values for different set of T-SOC pairs.

FIG. 6 schematically illustrates exemplary float capacity and differential float capacity over time.

FIG. 7 schematically illustrates an exemplary state of health (SOH) of a battery cell over time.

DETAILED DESCRIPTION

Some examples of the present disclosure generally provide for a plurality of circuits or other electrical devices. All references to the circuits and other electrical devices and the functionality provided by each are not intended to be limited to encompassing only what is illustrated and described herein. While particular labels may be assigned to the various circuits or other electrical devices disclosed, such labels are not intended to limit the scope of operation for the circuits and the other electrical devices. Such circuits and other electrical devices may be combined with each other and/or separated in any manner based on the particular type of electrical implementation that is desired. It is recognized that any circuit or other electrical device disclosed herein may include any number of microcontrollers, a graphics processor unit (GPU), integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, any one or more of the electrical devices may be configured to execute a program code that is embodied in a non-transitory computer readable medium programmed to perform any number of the functions as disclosed.

In the following, embodiments of the invention will be described in detail with reference to the accompanying drawings. It is to be understood that the following description of embodiments is not to be taken in a limiting sense. The scope of the invention is not intended to be limited by the embodiments described hereinafter or by the drawings, which are taken to be illustrative only.

The drawings are to be regarded as being schematic representations and elements illustrated in the drawings are not necessarily shown to scale. Rather, the various elements are represented such that their function and general purpose become apparent to a person skilled in the art. Any connection or coupling between functional blocks, devices, components, or other physical or functional units shown in the drawings or described herein may also be implemented by an indirect connection or coupling. A coupling between components may also be established over a wireless connection. Functional blocks may be implemented in hardware, firmware, software, or a combination thereof.

Various examples of the disclosure pertain to determining a set of calendar aging values of a test cell of a rechargeable battery, e.g., LIBs. The set of calendar aging values of the test cell of the rechargeable battery corresponds to a set of Temperature-State of Charge (T-SOC) value pairs. The set of calendar aging values of the test cell of the rechargeable battery is determined based on a battery-generic reference model for calendar aging of a (specific or random) battery cell and on a further set of calendar aging values of the test cell of the rechargeable battery. The further set of calendar aging values is obtained/derived from measurements of the test cell of the rechargeable battery and corresponds to a further set of T-SOC value pairs.

In general, the set of calendar aging values may indicate a correlation between calendar aging of the test cell of the rechargeable battery and storage conditions, e.g., parameters such as T and SOC. For example, the set of calendar aging values may comprise a set of capacity loss values of the test cell of the rechargeable battery. The set of capacity loss values may correspond to a set of T-SOC value pairs. Further, multiple sets of capacity loss values corresponding to the same set of T-SOC value pairs may be determined/measured/obtained at different measurement times. For a specific T-SOC pair, the capacity loss value for time t may be generally calculated using the following equation:

$$\text{Capacity loss} = 1 - \frac{\text{Capacity measured at time } t}{\text{initial Capacity}}$$

Additionally or alternatively, the set of calendar aging values may comprise impedance values of the test cell of the rechargeable battery. During the aging of a battery cell, the impedance of the cell rises over time. The larger the impedance, the higher the calendar aging value.

Generally, SOC is defined as the ratio of battery remaining capacity to its nominal capacity. The SOC is a value between 0% and 100% that indicates the relative level of charge presently held by the battery. The units of SOC are percentage points. A SOC of 100% corresponds to a "full" battery, while a SOC of 0% corresponds to an "empty" battery.

According to this disclosure, the battery-generic reference model for calendar aging of a battery cell may be obtained using any of the techniques disclosed prior to the filing date of this disclosure. For example, such techniques disclosed in a non-patent literature - Naumann, Maik; Schimpe, Michael; Keil, Peter; Hesse, Holger C.; Jossen, Andreas (2018): Analysis and modeling of calendar aging of a commercial LiFePO4/graphite cell. In Journal of Energy Storage 17, pp. 153-169. DOI: 10.1016/j.est.2018.01.019.

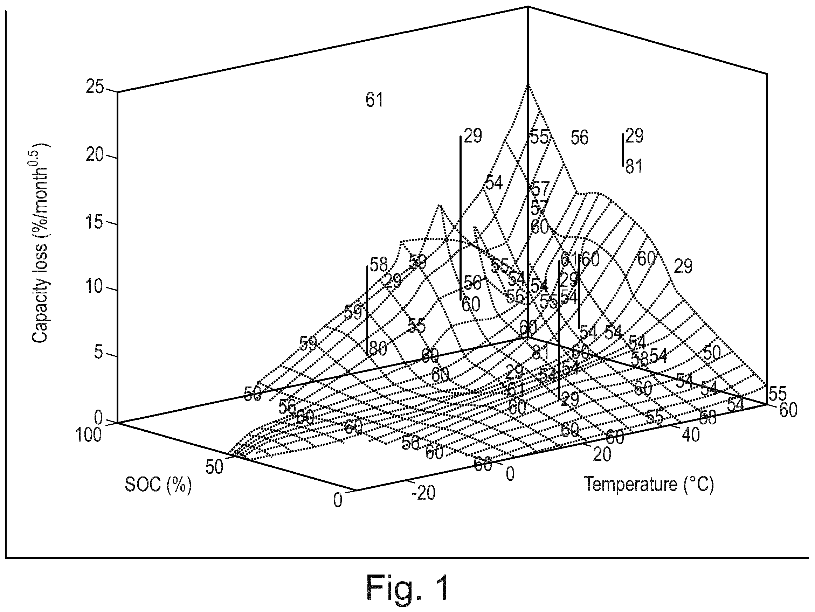

The battery-generic reference model for calendar aging of a battery cell may be visualized using what is in the following referred to as an aging grid. The aging grid shows the capacity loss of a battery cell. FIG. 1 schematically illustrates an exemplary aging grid of a battery-generic reference model for calendar aging of a battery cell according to various examples. The aging grid shows the capacity loss in %/month as a function of the storage temperature T and the SOC of one specific battery cell type. It is also possible to show the capacity loss in other units, e.g., %/2 months, %/week, %/2 weeks, %/15 days. It may be built on calendar aging tests of several dozen battery cells over years. By utilizing techniques disclosed herein, the aging grid may be transferred to other cell types which might differ either in the packaging, capacity, cell chemistry, stoichiometry, etc., and thereby a calendar aging model for each of those cells may be determined, e.g., a set of calendar aging values.

The techniques disclosed herein relate to determining a set of calendar aging values of a test cell of a rechargeable battery based on a battery-generic reference model for calendar aging of a battery cell - e.g., such as the one illustrated in FIG. 1 - and further based on a further set of measured calendar aging values of the test cell of the rechargeable battery. Accordingly, the testing time for performing calendar aging measurements can be significantly reduced, e.g., from several months to a few weeks. Further, the amount of available data characterizing the aging process of the test cell could be considerably increased. As such, the techniques disclosed herein enable determining the calendar aging values efficiently and precisely and can be widely applicable to various types of battery cells.

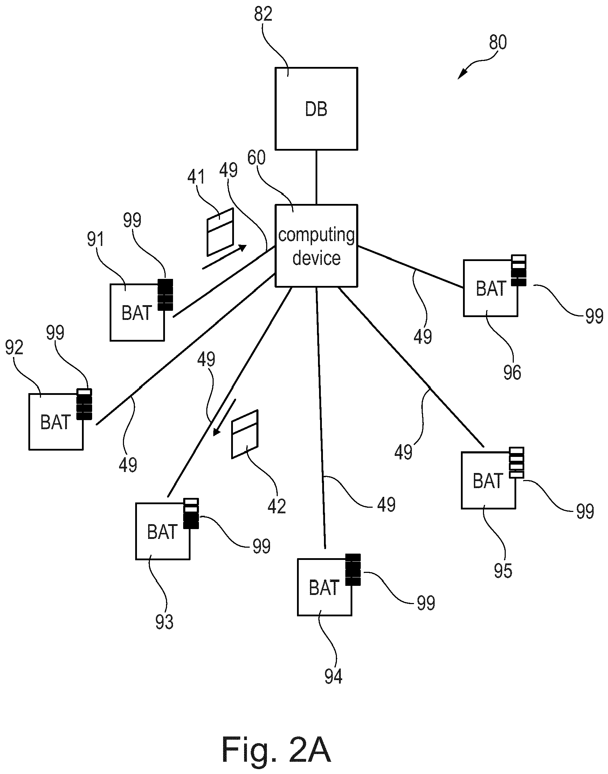

FIG. 2A illustrates aspects associated with a system 80. The system 80 comprises a computing device 60 which is connected to a database 82. In addition, the system 80 comprises communication connections 49 between the computing device 60 and each of several batteries 91-96. The communication connections 49 could be implemented, for example, via a cellular network.

In general, different battery types can be used in the various examples described herein. This means that the batteries 91-96 may comprise several types. Different types of batteries can be differentiated, for example, as relates to one or more of the following properties: shape of the cell (i.e., round cell, prismatic cell, etc.), cooling system (air cooling with active or passive design, coolant in coolant hose, passive cooling elements, etc.), the cell chemistry (e.g., electrode materials used, electrolytes, etc.), etc.

FIG. 2A illustrates by way of example that the batteries 91-96 of a given type can transmit state data 41 to the computing device 60 via the communication connections 49. For example, it would be possible for the state data 41 to be indicative of one or more operating values of the respective battery 91-96, i.e., it is possible to index measured data during storage tests. The state data 41 can be transmitted in an event-driven manner or according to a predefined timetable. The state data 41 may comprise information regarding idle times of the battery, voltage and/or current values, etc.. Based on such state data 41, it is possible to determine calendar aging for each one of the batteries 91-96 based on the techniques as outlined herein. A respective capacity 99 can be determined for each one of the batteries 91-96. The capacity can be determined based on a set of calendar aging values - e.g., defining an aging model - stored for the batteries 91-96. Such sets of calendar aging values may be stored for multiple types of batteries in the database 82. Based on the capacity 99 determined for each one of the batteries 91-96, it would be possible to control the operation of each one of the batteries 91-96. For instance, if the capacity 99 of a certain battery 91-96 degrades, it would be possible to apply restrictions or limitations to the operation of that battery 91-96. For instance, it would be possible to limit a charging rate or discharging rate. For example, it would be possible to limit the maximum SOC.

To investigate the rate and storage condition dependence of calendar aging, e.g., to determine a comprehensive set calendar aging values for multiple T-SOC value pairs, a test cell associated with the type of the batteries 91-96 may be stored at different SOCs and at different temperatures. For example, 16 storage SOCs from 0 to 100% may be examined. The investigated storage SOCs may comprise all multiples of 10% and additionally 5%, 45%, 55%, 65%, and 95% to obtain a finer resolution at very low SOC, at very high SOC, and in the medium SOC range. These 16 SOCs may be examined at storage temperatures of 25°C, 40°C, and 50°C. This may be done under laboratory conditions.

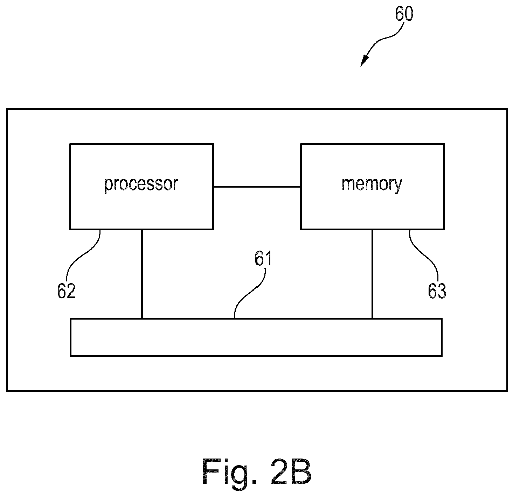

For instance, time-resolved measurements of capacity 99 and/or impedance of the test cell of each one of the batteries 91-96 can be provided to the computing device 60, e.g., a personal computer, via a respective communication interface 61 (cf. FIG. 2B). Based on this, the computing device 60 (e.g., a processor 62 of the computing device 60 based on program code stored in a memory 63) could determine calendar aging values at a specific temperature and at a specific SOC for the test cell. For this, the computing device 60 may access a database, e.g., the database 82, or memory where, e.g., one or more battery-generic reference models for calendar aging are stored. It would also be possible that the calendar aging values for a specific test cell are measured, e.g., in a laboratory setup. Then, the computing device 60 can determine a set of calendar aging values of the test cell based on a battery-generic reference model for calendar aging of a battery cell and on a further set of measured calendar aging values of the test cell.

Typically, it is possible to determine the set of calendar aging values based on measurements of the calendar aging values for a T-SOC value pair that is obtained in laboratory measurements. As a general rule, it would also be possible to obtain respective measurements from field-deployed batteries, e.g., the batteries 91-96, e.g., as part of the state data 41.

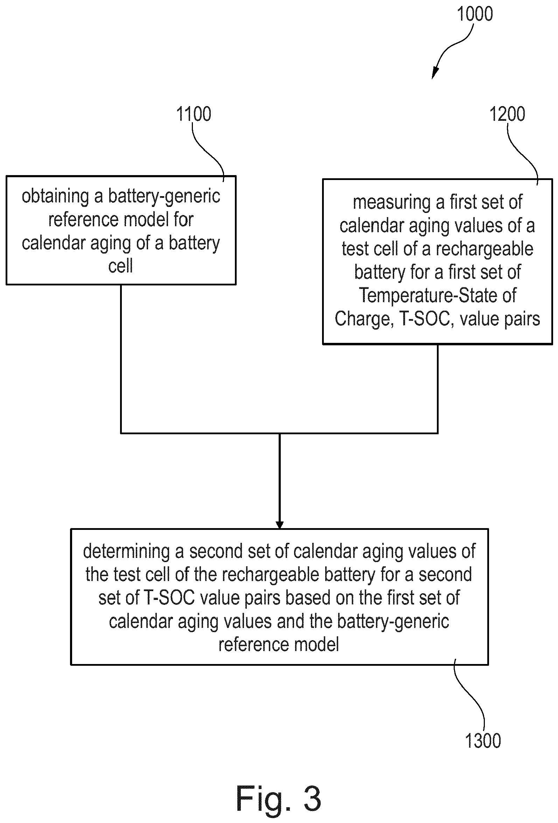

Next, techniques for determining calendar aging values of a test cell of a rechargeable battery are described in connection with FIG. 3.

FIG. 3 is a flowchart of a method 1000 according to various examples. The method 1000 pertains to determining calendar aging values of a test cell of a rechargeable battery, e.g., battery 91 of FIG. 2A. A calendar aging model of the test cell may be determined/built based on the determined calendar aging values.

The method 1000 of FIG. 3 may be executed by the computing device 60, e.g., by the processor 62 upon loading program code from the memory 63 and upon executing the program code.

At box 1100, a battery-generic reference model for calendar aging of a battery cell is obtained. The battery-generic reference model may be obtained via a communication interface from a database or data repository. The battery-generic reference model may be loaded from a memory.

For example, the battery-generic reference model may be represented using an aging grid like the one of FIG. 1. The battery-generic reference model for calendar aging may be built based on measurements obtained from any one of the batteries 92-96. The battery-generic reference model can be pre-determined. Prior art techniques for determining such battery-generic reference model can be used.

At box 1200, a first set of calendar aging values of the test cell of the rechargeable battery for a first set of T-SOC value pairs is measured.

The first set of T-SOC value pairs may be selected from a whole set of T-SOC value pairs associated with the battery-generic reference model. I.e., the first set of T-SOC value pairs may be a sub-set of all the T-SOC value pairs shown in the T-SOC plane of FIG. 1. For example, the first set of T-SOC value pairs may comprise (30°C, 60%), (30°C, 80%), and (60°C, 60%). After selecting or defining the first set of T-SOC value pairs, the first set of calendar aging values of the test cell of the rechargeable battery is measured for the first set of T-SOC value pairs, e.g., the three pairs (30°C, 60%), (30°C, 80%), and (60°C, 60%).

The first set of T-SOC value pairs may be comparatively sparse. I.e., only a limited number of T-SOC value payouts may be considered. This reduces the efforts and/or resources required to make respective measurements. For example, the required testing channels or climate chambers could be reduced.

Boxes 1100 and 1200 may be executed in parallel or in serial. For example, box 1100 may be executed first and then box 1200 is executed or vice versa.

At box 1300, a second set of calendar aging values of the test cell of the rechargeable battery for a second set of T-SOC value pairs is determined based on the first set of calendar aging values and the battery-generic reference model.

The second set of T-SOC value pairs may be all or a subset of the T-SOC value pairs shown in the T-SOC plane of FIG. 1. The second set of T-SOC value pairs can complement the first set of T-SOC value pairs. Accordingly, more data is available to make subsequent capacity estimations.

As an example, the second set of T-SOC value pairs corresponds to all the T-SOC value pairs shown in the T-SOC plane of FIG. 1. At block 1200, the first set of calendar aging values of the test cell of the rechargeable battery for the first set of T-SOC value pairs (30°C, 60%), (30°C, 80%), and (60°C, 60%) may be the following three capacity losses 10%, 15%, and 20%, respectively. The corresponding capacity losses for the first set of T-SOC value pairs derived from the battery-generic reference model are 8%, 13.5%, and 17%, respectively. Then, the second set of calendar aging values could be determined by re-scaling corresponding aging values derived from the battery-generic reference model based on one or more scaling factors, such as, 10%/8%, 15%/13.5%, and 20%/17%. For example, the calendar aging values for the remaining T-SOC pairs of the second set of T-SOC value pairs other than the first set of T-SOC value pairs, i.e., all the other T-SOC value pairs shown in the T-SOC plane of FIG. 1 except for (30°C, 60%), (30°C, 80%), and (60°C, 60%), could be determined by re-scaling corresponding calendar aging values derived from the battery-generic reference model based on the one or more scaling factors using interpolation techniques such as linear interpolation, polynomial interpolation, spline interpolation, and mimetic interpolation.

In other words, the method 1000 may further comprise, based on the battery-generic reference model, obtaining a reference set of calendar aging values of the test cell of the rechargeable battery for a reference set of T-SOC value pairs, and the second set of calendar aging values is determined by re-scaling the reference set of calendar aging values based on the first set of calendar aging values and by interpolating between at least the first set of calendar aging values in accordance with the re-scaled calendar aging values of the reference set. For example, the reference set of T-SOC value pairs may be all or a subset of the T-SOC value pairs shown in the T-SOC plane of FIG. 1. I.e., the reference set of T-SOC value pairs and the second set of T-SOC value pairs may be identical. The scaling factor of the reference set of calendar aging values may be determined based on the first set of calendar aging values, e.g., the three scaling factors 10%/8%, 15%/13.5%, and 20%/17% as described above.

Optionally or additionally, the battery-generic reference model may comprise a look-up table comprising the reference set of calendar aging values for the reference set of T-SOC value pairs. A specific one of the reference set of calendar aging values can be obtained by searching the look-up table using the corresponding T-SOC value pair.

Alternatively or additionally, the battery-generic reference model may comprise a patch-wise linear bivariate dependency of the reference set of calendar aging values. Using such techniques, it is possible to calculate the reference set of calendar aging values using the patch-wise linear bivariate dependency (e.g., on temperature and SOC). Different regions/patches in the temperature and SOC space can be associated with different linearity factors.

To further facilitate determination of the calendar aging values of the test cell of the rechargeable battery, relative aging values for a third set of T-SOC value pairs may be measured and a third set of calendar aging values may be determined based on the relative aging values for the third set of T-SOC value pairs. Accordingly, the calendar aging values of the test cell of the rechargeable battery is determined further based on the third set of calendar aging values.

Relative aging can pertain to a relative decrease of capacity (or increase of impedance), for different T-SOC operating points with respect to each other. Thus, a conclusion can be drawn that for certain T-SOC value pairs a stronger aging is observed that for other T-SOC value pairs. The absolute value of the aging cannot be determined directly from such relative aging values.

In other words, the method 1000 may further comprise measuring relative aging values for a third set of T-SOC value pairs, and determining a third set of calendar aging values of the test cell of the rechargeable battery for the third set of T-SOC value pairs based on the first set of calendar aging values and the relative aging values. The second set of the calendar aging values is determined further based on the third set of calendar aging values. For example, the relative aging values comprise float current values obtained during voltage hold. The float current values may be measured by holding the cell at a certain (or a pre-defined) voltage level. I.e., the float current values are the current values that are necessary to hold the cell at a certain voltage level. Further, the relative aging values may be, instead of float current (sometimes also referred to as float current measured during voltage hold), measurement of the reduction of voltage during open-circuit storage. A further example of the relative aging values may be obtained by performing high precision coulometry measurements (See: Smith, A. J., et al. "Interpreting high precision coulometry results on Liion cells." Journal of The Electrochemical Society 158.10 (2011): A1136). According to various examples, the third set of calendar aging values may be determined by extrapolating from the first set of calendar aging values in accordance with differences in the relative aging values.

Thus, the first set of calendar aging values may be used as extrapolation references for the extrapolation that is based on the third set of calendar aging values. In other words, the first set of calendar aging values is associated with an absolute strength of the aging and starting from the absolute strength the relative aging defined by the third set of calendar aging values can be used to find further absolute aging values.

Additionally or optionally, the method 1000 may further comprise determining the third set of T-SOC value pairs to lie across phase-transition regions of an active material of the test cell of the rechargeable battery. The phase transitions can be determined by applying Differential Voltage Analysis (DVA) of the Open Circuit Voltage (OCV) of a specific cell type. Additionally or optionally, it is possible to select more or even all the third set of T-SOC value pairs in regions of the T-SOC plane where phase transitions happen. I.e., it would be better to choose a more dense spacing of test points, i.e., more T-SOC value pairs, around (or close to) regions where phase transitions happen compared to where no phase transitions happen, since the calendar aging rate is assumed to change when the active materials undergo phase transitions.

Such techniques are based on the finding that phase-transition regions oftentimes prevented a meaningful extrapolation. This is because the relative aging will significantly change on different sides of a phase-transition region. Thus, by staying within the boundaries imposed by the phase-transition regions, reliable extrapolation is possible.

According to this disclosure, the third set of T-SOC value pairs may comprise the first set of T-SOC value pairs. I.e., the first set is a subset of the third set. Additionally or optionally, the first set of and the third set of T-SOC value pairs may be grid points of a regular T-SOC grid such as that shown in FIG. 1.

As a general rule, the determined second set of calendar aging values of the test cell of the rechargeable battery for the second set of T-SOC value pairs can be used for various use cases. For example, the determined second set of calendar aging values can be used to build a calendar aging model for the rechargeable battery, adjust the battery-generic reference model, and estimate a capacity degradation of a field cell of the rechargeable battery.

Optionally or additionally, the method 1000 may further comprise adjusting the battery-generic reference model based on the second set of calendar aging values. For example, the battery-generic reference model may be adjusted using a machine-learning algorithm trained using supervised learning, reinforcement learning, or unsupervised learning. For example, the machine-learning algorithm can optimize the battery-generic reference model by narrowing the data points, e.g., of FIG. 1.

Optionally or additionally, the method 1000 may further comprise tracking T-SOC values of a field cell of the rechargeable battery and estimating a capacity degradation of the field cell of the rechargeable battery using the second set of calendar aging values. When estimating the capacity degradation of the field cell of the rechargeable battery, the method 1000 may optionally or additionally comprise scaling the second set of calendar aging values based on a calendar age of the rechargeable battery.

The method 1000 determines a set of calendar aging values of a test cell of a rechargeable battery based on a battery-generic reference model for calendar aging of a battery cell and on a further set of measured calendar aging values of the test cell of the rechargeable battery. Accordingly, the testing time for performing calendar aging measurements can be significantly reduced, e.g., from several months to a few weeks. Further, the amount of available data characterizing the aging process of the test cell could be considerably increased. In addition, the method 1000 enables a transfer of a battery-generic reference model to other types of battery cells. As such, the techniques disclosed herein enable determining the calendar aging values efficiently and precisely and can be widely applicable to various types of battery cells.

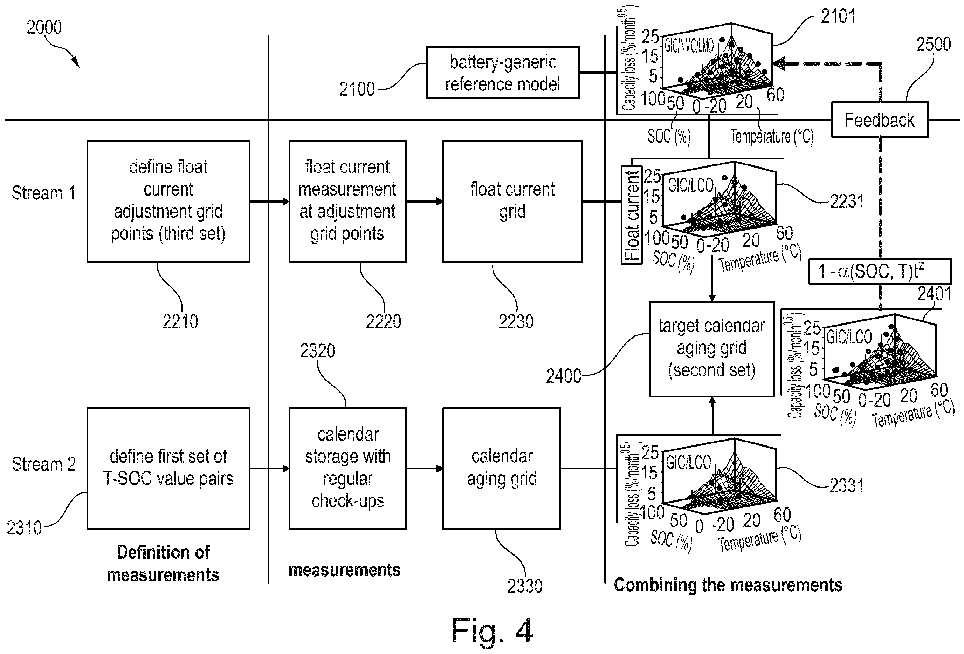

FIG. 4 schematically illustrates an exemplary workflow 2000 for determining a set of calendar aging values using the method 1000 of FIG. 3. Such an exemplary workflow 2000 is a preferred example but is not used to limit the scope of the disclosure. As shown in FIG. 4, capacity losses are utilized as an exemplary parameter indicating calendar aging, and float currents are utilized as an exemplary parameter indicating relative aging. Details with respect to the workflow 2000 will be explained below.

At box 2100, a battery-generic reference model for calendar aging of a battery cell is obtained. In FIG 4, the battery-generic reference model is represented/visualized by an aging grid 2101.

To determine a set of calendar aging values of a test cell of a rechargeable battery by transferring the battery-generic reference model to a test cell of any cell type, two measurement streams, i.e., stream 1 and stream 2, may be conducted. Stream 1 aims to measure relative aging values, i.e., float currents, for determining the third set of calendar aging values of the test cell of the rechargeable battery for the third set of T-SOC value pairs. On the other hand, stream 2 aims to measure the first set of calendar aging values of the test cell of the rechargeable battery for the first set of T-SOC value pairs. I.e., Stream 2 enables the absolute position of the target calendar aging grid (i.e., the second set of the calendar aging values).

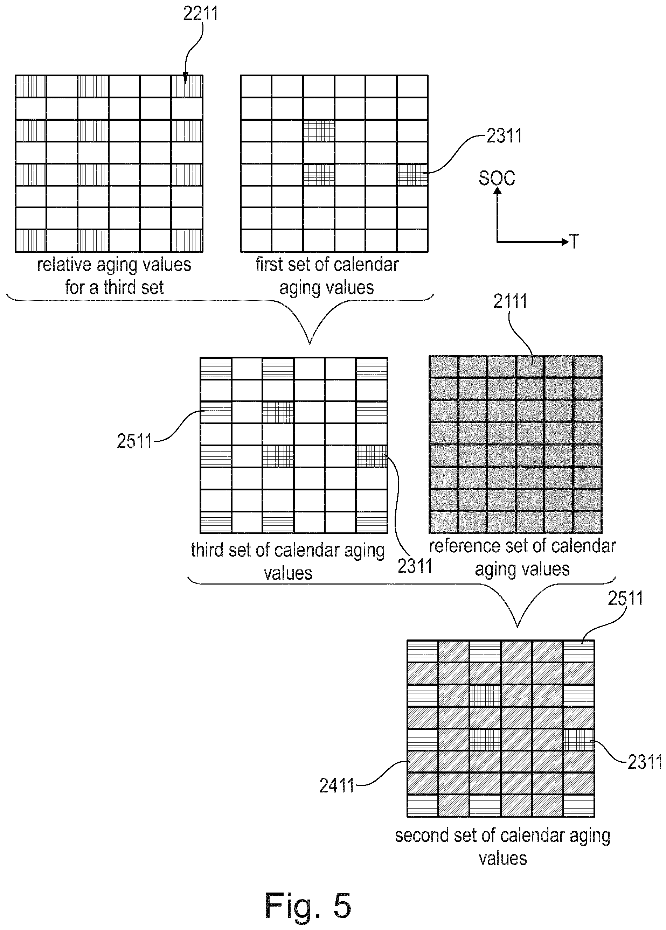

Next, details with respect to streams 1 and 2 will be described by referring to FIG. 4 and FIG. 5. FIG. 5 schematically illustrates various aging values for different sets of T-SOC pairs, in which different filling patterns indicate different aging values. Specifically, vertically striped lines, horizontally striped lines, grids, gray color, and upward diagonal striped lines respectively indicate the relative aging values 2211 for the third set of T-SOC value pairs, the third set of calendar aging values 2511 determined by extrapolating from the first set of calendar aging values in accordance with differences in the relative aging values, the first set of calendar aging values 2311, the reference set of calendar aging values 2111, the second set of calendar aging values 2411 which is determined by re-scaling the reference set of calendar aging values based on the first set of calendar aging values and by interpolating between at least the first set of calendar aging values in accordance with the re-scaled calendar aging values of the reference set.

Stream 1:

At box 2210, measurement points at specific temperatures (e.g. 10, 25, 40, 55°C) and SOCs (i.e., the third set of T-SOC value pairs) are defined for float current, i.e., defining float current adjustment grid points. Specific SOCs may be defined by using phase transition regions of the active materials of the test cell. The phase transitions can be determined by applying DVA of the OCV of the specific cell type.

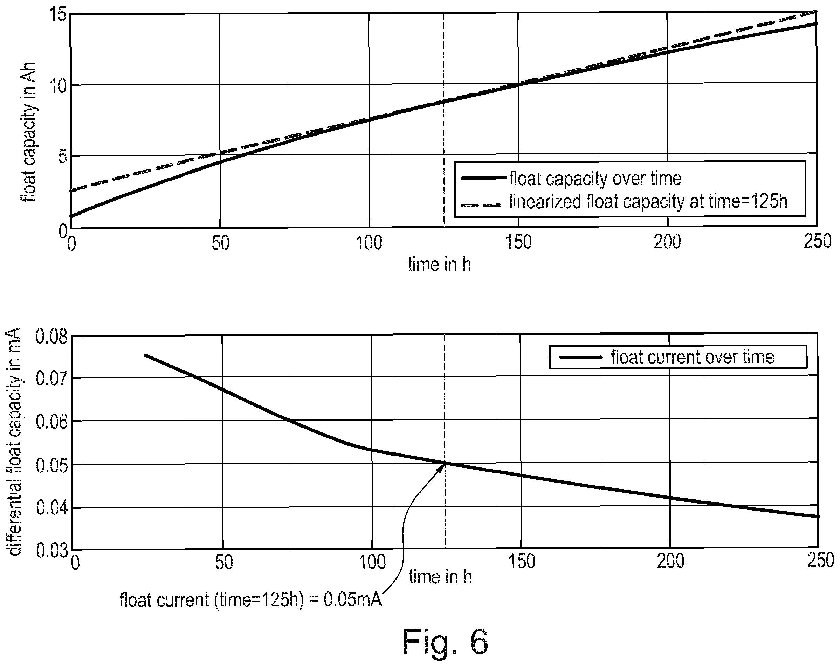

At box 2220, float current measurements 2211 are conducted. Specifically, the test cell is stored at specific SOCs and temperatures as defined at box 2210. Over a time period of, e.g., around 14 days, the test cell held continuously on the SOC-specific voltage level. Because of side reactions, a small current can be measured. That current is called a float current and is associated with the degradation rate at a specific T-SOC pair. Additionally, it is also possible to track the change of float current over time, instead of only the constant float current value, in order to estimate the change of the calendar aging rate over time. If the measured float currents are noisy, e.g. because of the resolution of the measurement device, the float capacity can be used to calculate the float current. As shown in FIG. 6, the float capacity is calculated by integrating the float current signal over a time period. The slope of a linear fit of this float capacity over time equals to the float current. After a period of time, e.g., one week, 14 days, one month, the temperature can be changed. Using multiple cells of the same cell type, several SOC grid points can be measured in parallel.

At box 2230, the result of stream 1 is obtained, i.e., a grid 2231 of float currents in dependence on storage SOC and temperature. This grid 2231 is referred to as "float current grid".

Stream 2:

At box 2310, some of the measurement points, i.e., T-SOC pairs, defined at box 2210 are selected for "standard" calendar aging tests.

At box 2320, the first set of calendar aging values 2311 of the test cell is measured. Specifically, the test cell is stored at specific SOC and Temperature levels, and the capacity of the test cell is measured after a specific time interval, e.g. 4 weeks, during a check-up cycle.

At box 2330, from the check-up cycles of the standard calendric aging tests, a grid 2331 of capacity loss in %/month (or other units, e.g., %/2 months, %/week, %/2 weeks, %/15 days) as a function of storage temperature and SOC is obtained. This grid 2331 is referred to as "calendar aging grid" and has fewer grid points than the generic aging grid 2101 obtained at box 2100.

Next, at box 2400, the measurements obtained in streams 1 and 2 are combined to determining the second set of calendar aging values of the test cell. The resulting degradation functions, e.g., visualized by the grid 2331, from the check-ups are used as supporting points to set the absolute level of the target calendar aging model.

The "float current grid" 2231 and "calendar aging grid" 2331 and "generic grid" 2101 are combined to form the "target calendar aging grid" 2401 as follows:

The values of the target calendar aging grid at the grid points (first set) of stream 2 are taken from the "calendar aging grid", i.e., 2311.

The remaining grid points 2511 of the third set are calculated from the relative difference in float current between these grid points and the grid points of stream 1 (third set).

Additional grid points 2411 between the grid points of stream 1 (third set) are interpolated using the generic aging grid 2101, i.e., points 2111.

As such, the second set of calendar aging values of the test cell is determined as a combination of points/values 2311, 2411, 2511, and thereby a transferred calendar aging model in absolute and relative manner is implemented.

Further, at box 2500, the second set of calendar aging values of the test cell can be used to recalibrate the surface function of the generic aging model, e.g., the aging grid 2101.

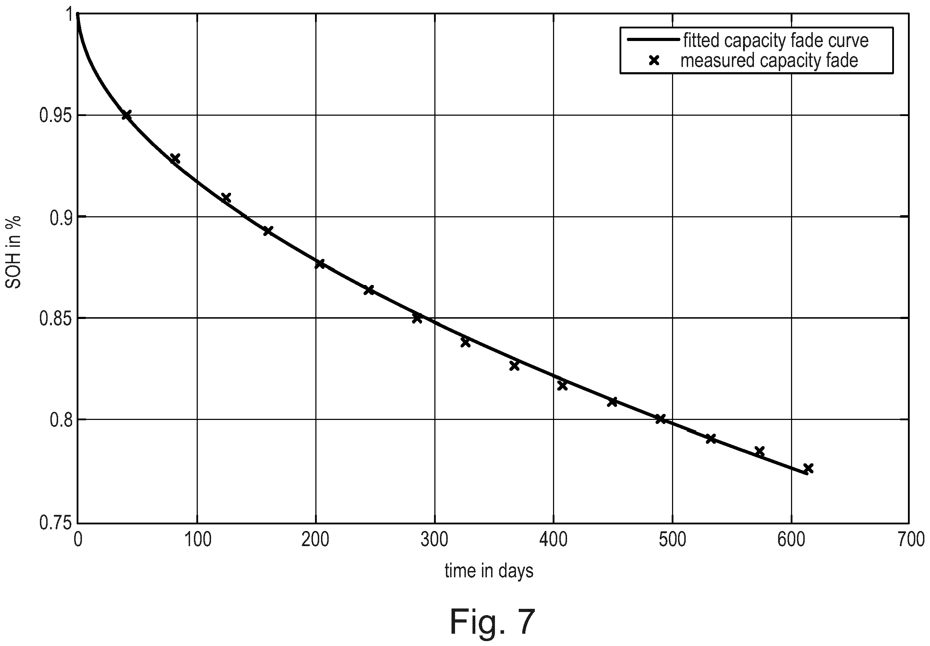

FIG.7 schematically illustrates an exemplary SOH of a battery cell over time. As a general rule, the SOH of battery cells is determined by battery capacity fade and battery power fade. Capacity fade can be described as a loss of usable energy (or charge carrier) storage capability, whereas power fade means the loss of instantaneous power, that the battery can deliver. Therefore, alternatively or additionally, the calendar aging values of this disclosure may comprise SOH and/or battery power fade. For example, the calendar aging values may be defined as a function of SOH.

Summarizing, techniques have been described that facilitate determination of calendar aging values of a cell of a rechargeable battery. The techniques disclosed herein determine a set of calendar aging values of a test cell of a rechargeable battery based on a battery-generic reference model for calendar aging of a battery cell and on a further set of measured calendar aging values of the test cell of the rechargeable battery. Accordingly, the testing time for performing calendar aging measurements can be significantly reduced, e.g., from several months to a few weeks. Further, the amount of available data characterizing the aging process of the test cell could be considerably increased. In addition, the disclosed techniques enable a transfer of a battery-generic reference model to other types of battery cells. As such, the techniques disclosed herein enable determining the calendar aging values efficiently and precisely and can be widely applicable to various types of battery cells.

Although the invention has been shown and described with respect to certain preferred embodiments, equivalents and modifications will occur to others skilled in the art upon the reading and understanding of the specification. The present invention includes all such equivalents and modifications and is limited only by the scope of the appended claims.

For illustration, while scenarios of calendar aging depending on temperature and state of charge value pairs have been disclosed, other or further parameters could be considered, e.g., environmental parameters such as air humidity, air pressure, or battery-specific parameters such as externally applied pressure.

**Claims**

1. A computer-implemented method (1000), comprising:

   - obtaining (1100) a battery-generic reference model for calendar aging of a battery cell,
   - measuring (1200) a first set of calendar aging values (2311) of a test cell of a rechargeable battery (92-96) for a first set of Temperature-State of Charge, T-SOC, value pairs, and
   - determining (1300) a second set of calendar aging values (2411) of the test cell of the rechargeable battery (92-96) for a second set of T-SOC value pairs based on the first set of calendar aging values (2311) and the battery-generic reference model.

2. The computer-implemented method (1000) of claim 1, further comprising:

   - measuring relative aging values (2211) for a third set of T-SOC value pairs, and
   - determining a third set of calendar aging values (2511) of the test cell of the rechargeable battery (92-96) for the third set of T-SOC value pairs based on the first set of calendar aging values (2311) and the relative aging values (2211),

   wherein the second set of the calendar aging values (2411) is determined further based on the third set of calendar aging values (2511).

3. The computer-implemented method (1000) of claim 2, wherein the third set of calendar aging values (2511) is determined by extrapolating from the first set of calendar aging values (2311) in accordance with differences in the relative aging values (2211).

4. The computer-implemented method (1000) of claim 2 or 3, further comprising:

   - determining the third set of T-SOC value pairs to lie across phase-transition regions of an active material of the test cell of the rechargeable battery (92-96).

5. The computer-implemented method (1000) of any one of claims 2 to 4, wherein the relative aging values (2211) comprise float current values.

6. The computer-implemented method (1000) of claim 5, wherein the float current values are measured by holding the test cell at a pre-defined voltage level.

7. The computer-implemented method (1000) of any one of claims 2 to 6, wherein the third set of T-SOC value pairs comprises the first set of T-SOC value pairs.

8. The computer-implemented method (1000) of any one of claims 2 to 7, wherein the first set of and the third set of T-SOC value pairs are grid points of a regular T-SOC grid.

9. The computer-implemented method (1000) of any one of the preceding claims, further comprising:

   - based on the battery-generic reference model, obtaining a reference set of calendar aging values (2111) of the test cell of the rechargeable battery (92-96) for a reference set of T-SOC value pairs,

   wherein the second set of calendar aging values (2411) is determined by re-scaling the reference set of calendar aging values (2111) based on the first set of calendar aging values (2311) and by interpolating between at least the first set of calendar aging values (2311) in accordance with the re-scaled calendar aging values of the reference set.

10. The computer-implemented method (1000) of claim 9, wherein a scaling factor of the reference set of calendar aging values (2111) is determined based on the first set of calendar aging values (2311).

11. The computer-implemented method (1000) of claim 9 or 10, wherein the battery-generic reference model comprises a look-up table comprising the reference set of calendar aging values (2111) for the reference set of T-SOC value pairs.

**12.** The computer-implemented method (1000) of claim 9 or 10,
wherein the battery-generic reference model comprises a patch-wise linear bivariate dependency of the reference set of calendar aging values (2111).

**13.** The computer-implemented method (1000) of any one of the preceding claims, further comprising:

- adjusting the battery-generic reference model based on the second set of calendar aging values (2411).

**14.** The computer-implemented method (1000) of claim 13,
wherein the battery-generic reference model is adjusted using a machine-learning algorithm.

**15.** The computer-implemented method (1000) of any one of the preceding claims, further comprising:

- tracking T-SOC values of a field cell of the rechargeable battery,
- estimating a capacity degradation of the field cell of the rechargeable battery (92-96) using the second set of calendar aging values (2411).

**16.** The computer-implemented method (1000) of claim 15, further comprising:

- when estimating the capacity degradation of the field cell of the rechargeable battery (92-96), scaling the second set of calendar aging values (2411) based on a calendar age of the rechargeable battery (92-96).

**17.** A computing device (60) comprising a processor (62) and a memory (63), wherein upon loading and executing program code from the memory (63), the processor (62) is configured to perform the method (1000) according to any one of the preceding claims.

**18.** A computer program comprising program code executable by at least one processor, wherein the at least one processor, upon executing the program code, performs the method (1000) of any one of claims 1 to 16.

Fig. 1

Fig. 2A

60

processor

memory

62    61    63

Fig. 2B

1000

1100

obtaining a battery-generic reference model for calendar aging of a battery cell

1200

measuring a first set of calendar aging values of a test cell of a rechargeable battery for a first set of Temperature-State of Charge, T-SOC, value pairs

determining a second set of calendar aging values of the test cell of the rechargeable battery for a second set of T-SOC value pairs based on the first set of calendar aging values and the battery-generic reference model

1300

Fig. 3

Fig. 4

2000

2100 — battery-generic reference model

2101

GIC/NMC/LMO

Capacity loss (%/month$^{0.5}$): 25 15 5

SOC (%): 100 50 0

Temperature (°C): -20 20 60

2500

Feedback

Stream 1

define float current adjustment grid points (third set)

2210

float current measurement at adjustment grid points

2220

float current grid

2230

Float current: 25 15 5

GIC/LCO

SOC (%): 100 50 0

Temperature (°C): -20 20 60

2231

$1 - \alpha(SOC, T)t^z$

2401

GIC/LCO

Capacity loss (%/month$^{0.5}$): 25 15 5

SOC (%): 100 50 0

Temperature (°C): -20 20 60

2400 — target calendar aging grid (second set)

Stream 2

define first set of T-SOC value pairs

2310

2320

calendar storage with regular check-ups

calendar aging grid

2330

GIC/LCO

Capacity loss (%/month$^{0.5}$): 25 15 5

SOC (%): 100 50 0

Temperature (°C): -20 20 60

2331

**Definition of measurements**

**measurements**

**Combining the measurements**

EP 4 332 598 A1

Fig. 5

Fig. 6

Fig. 7

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | SWIERCZYNSKI MACIEJ ET AL: "Suitability of the nanophosphate LiFePO4/C battery chemistry for the fully electric vehicle: Lifetime perspective", 2014 NINTH INTERNATIONAL CONFERENCE ON ECOLOGICAL VEHICLES AND RENEWABLE ENERGIES (EVER), IEEE, 25 March 2014 (2014-03-25), pages 1-8, XP032611897, DOI: 10.1109/EVER.2014.6844119 [retrieved on 2014-06-25] * Section III. A. * | 1-18 | INV. G01R31/392 G01R31/367 |
| X | WO 2010/055271 A1 (PEUGEOT CITROEN AUTOMOBILES SA [FR]; PORCELLATO DENIS [FR]) 20 May 2010 (2010-05-20) * page 4, line 33 - page 5, line 7; figure 1 * | 1-18 | |
| A | LIU KAILONG ET AL: "A Transferred Recurrent Neural Network for Battery Calendar Health Prognostics of Energy-Transportation Systems", IEEE TRANSACTIONS ON INDUSTRIAL INFORMATICS, IEEE SERVICE CENTER, NEW YORK, NY, US, vol. 18, no. 11, 24 January 2022 (2022-01-24), pages 8172-8181, XP011920515, ISSN: 1551-3203, DOI: 10.1109/TII.2022.3145573 [retrieved on 2022-01-25] * Sections I, II * | 1-18 | TECHNICAL FIELDS SEARCHED (IPC)   G01R |
| A | CN 114 019 380 A (TIANJIN EV ENERGIES CO LTD) 8 February 2022 (2022-02-08) * claim 1 * | 1-18 | |

-/--

The present search report has been drawn up for all claims

| Place of search | Date of completion of the search | Examiner |
|---|---|---|
| Munich | 16 February 2023 | Meliani, Chafik |

EPO FORM 1503 03.82 (P04C01)

page 1 of 2

Europäisches
Patentamt

European
Patent Office

Office européen
des brevets

# EUROPEAN SEARCH REPORT

**Application Number**

EP 22 19 3100

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LEWERENZ MEINERT ET AL: "New method evaluating currents keeping the voltage constant for fast and highly resolved measurement of Arrhenius relation and capacity fade", JOURNAL OF POWER SOURCES, ELSEVIER, AMSTERDAM, NL, vol. 353, 7 April 2017 (2017-04-07), pages 144-151, XP029983139, ISSN: 0378-7753, DOI: 10.1016/J.JPOWSOUR.2017.03.136 * Sections 2, 3 * | 1-18 | |
| A | US 2016/239592 A1 (POURMOUSAVI KANI SEYYED ALI [US]) 18 August 2016 (2016-08-18) * claim 1 * | 1-18 | |
| A | LIU KAILONG ET AL: "Gaussian Process Regression With Automatic Relevance Determination Kernel for Calendar Aging Prediction of Lithium-Ion Batteries", IEEE TRANSACTIONS ON INDUSTRIAL INFORMATICS, IEEE SERVICE CENTER, NEW YORK, NY, US, vol. 16, no. 6, 2 October 2019 (2019-10-02), pages 3767-3777, XP011777074, ISSN: 1551-3203, DOI: 10.1109/TII.2019.2941747 [retrieved on 2020-03-05] * Section II * | 1-18 | TECHNICAL FIELDS SEARCHED (IPC) |

The present search report has been drawn up for all claims

| Place of search | Date of completion of the search | Examiner |
|---|---|---|
| Munich | 16 February 2023 | Meliani, Chafik |

EPO FORM 1503 03.82 (P04C01)

## ANNEX TO THE EUROPEAN SEARCH REPORT
## ON EUROPEAN PATENT APPLICATION NO.

EP 22 19 3100

This annex lists the patent family members relating to the patent documents cited in the above-mentioned European search report.
The members are as contained in the European Patent Office EDP file on
The European Patent Office is in no way liable for these particulars which are merely given for the purpose of information.

16-02-2023

| Patent document cited in search report | | Publication date | Patent family member(s) | | Publication date |
|---|---|---|---|---|---|
| WO 2010055271 | A1 | 20-05-2010 | CN 102216794 | A | 12-10-2011 |
| | | | EP 2361390 | A1 | 31-08-2011 |
| | | | FR 2938658 | A1 | 21-05-2010 |
| | | | WO 2010055271 | A1 | 20-05-2010 |
| CN 114019380 | A | 08-02-2022 | NONE | | |
| US 2016239592 | A1 | 18-08-2016 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **NAUMANN, MAIK ; SCHIMPE, MICHAEL ; KEIL, PETER ; HESSE, HOLGER C. ; JOSSEN, ANDREAS.** Analysis and modeling of calendar aging of a commercial LiFePO4/graphite cell. *Journal of Energy Storage,* 2018, vol. 17, 153-169

- **SMITH, A. J. et al.** Interpreting high precision coulometry results on Liion cells. *Journal of The Electrochemical Society,* 2011, vol. 158 (10), A1136